# EUROPEAN PATENT SPECIFICATION

(11) **EP 4 354 496 B1**
(45) Date of publication and mention of the grant of the patent: **14.05.2025**
(21) Application number: 22201462.3
(22) Date of filing: 13.10.2022
(51) Int. Cl.: H01L 21/761, H10D 62/10, H01L 21/762, H01L 21/763

(54) **ISOLATION STRUCTURE FOR AN ACTIVE COMPONENT**
ISOLATIONSSTRUKTUR FÜR EIN AKTIVES BAUELEMENT
STRUCTURE D'ISOLATION POUR UN COMPOSANT ACTIF

(43) Date of publication of application: 17.04.2024
(73) Proprietor: NXP B.V., 5656 AG Eindhoven (NL)
(72) Inventor: MEHROTRA, Saumitra Raj, 5656 AG Eindhoven (NL); ZHU, Ronghua, 5656 AG Eindhoven (NL); ROGGENBAUER, Todd, 5656 AG Eindhoven (NL)
(74) Representative: Schmütz, Christian Klaus Johannes

(56) References cited:
- EP-A1- 3 553 822
- CN-A- 104 362 095
- US-A1- 2007 063 274
- US-A1- 2022 190 116

## Description

### BACKGROUND

The present specification relates to isolation structures for an active component in a semiconductor device. In particular, the present specification relates to trench isolation.

Bipolar CMOS DMOS (BCD) process technology enables incorporation of analog components, digital components and high voltage (HV) devices into a single chip or integrated circuit (IC). These components are designed such that they do not interfere with (for example, latch up with) adjacent components on a substrate. Hence, there is a need to properly isolate adjacent components from each other. A variety of different isolation schemes exist such as junction-based isolation or trench-based isolation in a bulk wafer or trench-based isolation in a SOI (Silicon -on-insulator) wafer.

A typical design of a trench-based isolation involves a heavily doped buried layer (BL) that intersects a trench oxide where the trench is partially or fully filled with oxide.

Documents EP3553822 A1, US2022190116 A1, US2007063274 A1 and CN104362095 A disclose semiconductor devices comprising buried layers to create an isolation structure.

### SUMMARY

Aspects of the present disclosure are set out in the accompanying independent and dependent claims.

According to a first aspect of the present disclosure, there is provided a semiconductor device comprising a substrate having a first conductivity type, the substrate having a top surface and a bottom surface. A first buried layer is disposed in the substrate at a first depth from the top surface, wherein the first buried layer has a second conductivity type and a first doping concentration. A second buried layer is adjacent to and surrounds the first buried layer at the first depth, wherein the second buried layer has the second conductivity type and a second doping concentration, wherein the second doping concentration is less than the first doping concentration. An isolation trench is disposed in the substrate and surrounds the second buried layer, wherein the isolation trench extends from the top surface of the substrate to a second depth, the second depth exceeding the first depth.

It will be appreciated that the second conductivity type is different to the first conductivity type.

The second buried layer is perimetric to the first buried layer. The isolation trench is perimetric to the second buried layer.

Optionally, the first doping concentration may be of the order of 10¹⁸/cm³ or 10¹⁹/cm³. Optionally, the first doping concentration may be between 5x10¹⁸/cm³ and 5x10¹⁹/cm³.

In some embodiments the first buried layer may comprise at least two doping species.

Optionally, the second doping concentration is of the order of 10¹⁶/cm³ or 10¹⁷/cm³. Optionally, the second doping concentration may be between 5x10¹⁶/cm³ and 5x10¹⁷/cm³.

It will be appreciated that the doping concentrations referred to in the present disclosure may be the peak doping concentration for the respective semiconductor layer.

Optionally, the substrate comprises a base substrate and at least one epitaxial layer disposed over the base substrate. The at least one epitaxial layer may have the first conductivity type. The isolation trench and the first and second buried layers may be disposed in the at least one epitaxial layer. Thus, the top surface of the substrate may be the top surface of the at least one epitaxial layer. The bottom surface of the substrate may be a bottom surface of the base substrate. It will be appreciated that various multi-layer substrates could be used.

In some embodiments, the semiconductor device further comprises a first well region disposed between the top surface of the substrate and the first buried layer. The first well region may have the second conductivity type. The first well region may be bounded by the isolation trench.

In some embodiments, the semiconductor device further comprises an active component provided in the first well region. Optionally, the active component may be a transistor, or a diode, but is not limited to these examples.

Optionally, a second well region may be disposed between the first well region and the isolation trench. The second well region may have the second conductivity type and may surround the first well region.

The second well region may be perimetric to the first well region. The isolation trench may be perimetric to the second well region.

Optionally, the second well region may have a doping concentration that is the same as, or of the same order as, the second doping concentration.

In some embodiments, the second well region may have a doping concentration that is of the order of 10¹⁶/cm³.

In some embodiments, the first well region may have a doping concentration that is of the order of 10¹⁷/cm³ or 10¹⁸/cm³. Optionally, the first well region may have a doping concentration that is between the first doping concentration and the second doping concentration.

Optionally, a width of the second buried layer is less than a width of the first buried layer. The width of the second buried layer is the distance between the isolation trench and the first buried layer.

Optionally, a width of the second buried layer between the isolation trench and the first buried layer is at least 1 µm. Optionally, a width of the second buried layer between the isolation trench and the first buried layer is between 1 and 5 µm.

Optionally, the isolation trench contains a polysilicon material.

Optionally, the first and second buried layers have the same height.

Optionally, the second buried layer is configured such that a breakdown region is spaced from the isolation trench. The breakdown region is defined as a region or location which is susceptible to electrical breakdown due to a high electric field strength. This may also be referred to as an electrical hotspot.

Optionally, the second buried layer is configured such that the breakdown region is located proximate a junction between the first buried layer and the second buried layer. Optionally, the second buried layer is configured such that the breakdown region is located proximate an edge of the first buried layer.

Thus, the breakdown region may be spaced from the trench by a distance equal to the width of the second buried layer.

According to a second aspect of the present disclosure, there is provided a method of manufacturing a semiconductor device, comprising providing a substrate having a first conductivity type, the substrate having a top surface and a bottom surface, providing a first buried layer in the substrate at a first depth from the top surface, wherein the first buried layer has a second conductivity type and a first doping concentration, providing a second buried layer adjacent and surrounding the first buried layer at the first depth, wherein the second buried layer has the second conductivity type and a second doping concentration, wherein the second doping concentration is less than the first doping concentration, and providing an isolation trench in the substrate surrounding the second buried layer, wherein the isolation trench extends from the top surface of the substrate to a second depth, the second depth exceeding the first depth.

It will be appreciated that the method may comprise method steps for manufacturing a semiconductor device according to any embodiment or example of the first aspect of the disclosure.

Optionally, the first and second buried layers may be inserted or implanted in a single step.

Optionally, the method may include providing a first well region between the top surface of the substrate and the first buried layer. The first well region may have the second conductivity type.

Optionally, the method may include providing a second well region between the isolation trench and the first well region, such that the second well region surrounds or is perimetric to the first well region. The second well region may have the second conductivity type. The second well region may have a lower doping concentration than the first well region.

Optionally, the first and second well regions may be inserted or implanted in a single step. Optionally, the first and second well regions may be inserted or implanted before the isolation trench is provided.

The method may include providing a polysilicon material in the isolation trench.

The method may comprise providing a base substrate, the base substrate having the first conductivity type. The method may comprise providing a first epitaxial layer over the base substrate, the first epitaxial layer having the first conductivity type.

The method may include implanting the first and second buried layers into the first epitaxial layer. A second epitaxial layer may be grown over the first epitaxial layer and the first and second buried layers.

### BRIEF DESCRIPTION OF THE DRAWINGS

Illustrative embodiments of this disclosure will be described hereinafter, by way of example only, with reference to the accompanying drawings in which like reference signs relate to like elements and in which:
**Figure 1** - shows a cross-sectional view of a prior art semiconductor device;
**Figure 2** - shows a cross-sectional view of another prior art semiconductor device;
**Figure 3****-** shows a cross-sectional view of a semiconductor device according to an embodiment of the present disclosure;
**Figure 4****-** shows a top view of a semiconductor device according to an embodiment of the present disclosure;
**Figure 5** - is a graph showing how, in one embodiment of the present disclosure, doping concentration varies with depth along line A in Figure 3;
**Figure 6** - is a graph showing how, in one embodiment of the present disclosure, doping concentration varies with depth along line B in Figure 3; and
**Figure 7** - is flowchart of a method of manufacture according to an embodiment of the present disclosure.

### DETAILED DESCRIPTION

Embodiments of this disclosure are described in the following with reference to the accompanying drawings. It will be appreciated that the drawings are schematic illustrations and are not drawn to scale.

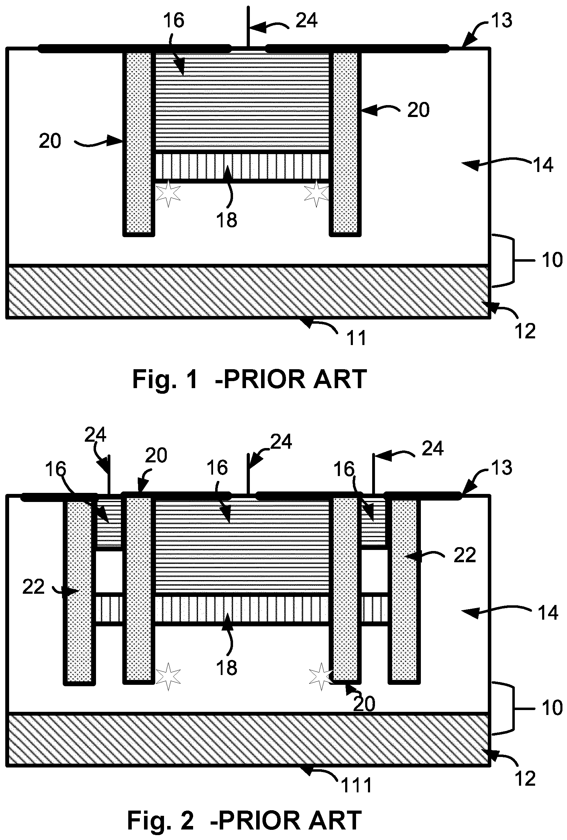

Figure 1 is a cross-sectional view of a prior art semiconductor device. The semiconductor device comprises a substrate 10 formed of a base substrate 12 and at least one epitaxial layer 14 formed on top of the base substrate 12. The substrate 10 has a bottom surface 11 and a top surface 13. It will be appreciated that in some embodiments the substrate 10 may be a single layer, or the substrate may have a plurality of different layers.

A heavily doped buried layer 18 is disposed in the substrate 10 at a depth from the top surface 13 of the substrate. The buried layer 18 is surrounded by an isolation trench 20. The trench 20 is usually filled with an oxide material. A well region 16 is disposed between the top surface 13 and the buried layer 18. The well region 16 is bounded by (or surrounded by) the trench 20. At least one electrical contact 24 is electrically connected to the well region 16 and the buried layer 18. The electrical contact(s) 24 control the potential of the buried layer 18.

In use (but not shown in Figure 1) an active component is disposed in the well region 16. The isolation trench 20 and buried layer 18 are provided to attempt to electrically isolate the active component from neighbouring components on the substrate 10, such that adjacent active components do not interfere with each other. The trench 20 provides a physical barrier, due to the oxide filling, and the buried layer 18, provides an electrical barrier.

However, it has been found that the semiconductor device shown in Figure 1 is susceptible to breakdown voltage shift over time. Avalanche breakdown occurs when an electric field generated by a voltage in a semiconducting region exceeds a critical value, such that the object becomes a conductor. This is because the electric field becomes strong enough generate a lot of electron/hole pairs that create a lot of current quickly. The breakdown voltage of an object is the voltage at which this breakdown occurs. The breakdown voltage depends on a variety of factors including the composition and shape of the object.

Accordingly, electrical breakdown usually initiates at the region that has the highest electric field. In this disclosure this region is called the breakdown region, or hotspot region, and is represented by a star in Figures 1 to 3.

If there is a shift in the breakdown voltage over time, this means that the voltage at which electrical breakdown occurs is not stable and changes over time. If the breakdown voltage shifts to lower voltages over time, then this can result in the isolation structure failing when the semiconductor device is subjected to high voltages.

It has been found that the breakdown voltage of the prior art in Figure 1 shifts to lower voltages over time. This is because the breakdown region (i.e., the high electric field region at which breakdown occurs) is located proximate to the trench 20, as shown by the stars. This causes the breakdown voltage to change over time due to hot electron or hot hole injection towards the trench oxide causing Ox-Si interface charging, or possibly due to hot electron or hot hole injection landing in the conductive polysilicon region of the trench.

Another prior art example is shown in Figure 2. Features which are common between figures 1 and 2 have been given the same reference numeral. In Figure 2, there is a second isolation trench 22 provided, which is spaced from and surrounds the first isolation trench 20. Both trenches 20, 22 intersect the buried layer 18 and at least a portion of the well region 16. The trenches 20, 22 may be filled with an oxide, or polysilicon material. Due to this dual trench structure, the high electric field region (or breakdown region) is located proximate the inner edge of the first trench 20, as shown by the stars in Figure 2. Again, it has been found that the semiconductor device shown in Figure 2 is susceptible to breakdown voltage (BV) shift over time. As stated above, this BV shift can be caused due to hot electron or hot hole injection towards the trench oxide causing Ox-Si interface charging, or possibly due to hot electron or hot hole injection landing in the conductive polysilicon region of the trench.

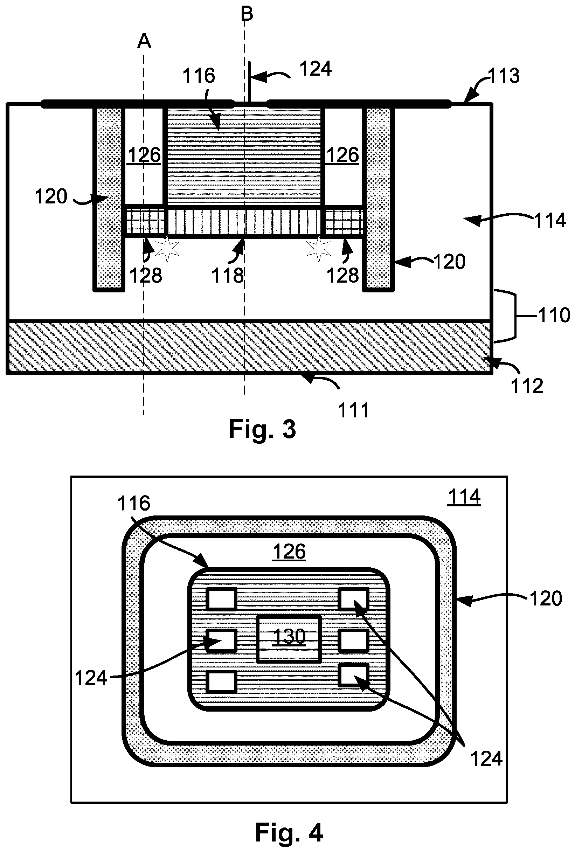

A cross-sectional view of a semiconductor device according to an embodiment of the present invention is shown in Figure 3.

The semiconductor device comprises a substrate 110 formed of a base substrate 112 and at least one epitaxial layer 114 formed on top of the base substrate 112. The substrate 110 has a bottom surface 111 and a top surface 113. It will be appreciated that in some embodiments the substrate 110 may be a single layer, or the substrate may have a plurality of different layers. The substrate 110 has a first conductivity type, for example positive or p conductivity.

A first buried layer 118 is disposed in the substrate 110 at a depth from the top surface 113 of the substrate. The first buried layer 118 has a second conductivity type, which is different to the conductivity type of the substrate 110. The first buried layer 118 is doped at a first doping concentration.

A second buried layer 128 is disposed in the substate 110 at the same depth as the first buried layer 118. The second buried layer 128 is adjacent to and surrounds the first buried layer 118. Thus, the second buried layer 128 is perimetric to the first buried layer 118.

The second buried layer 128 has a second conductivity type (opposite to the substrate 110 and the same as the first buried layer 118). The second buried layer 128 is doped at a second doping concentration. The second doping concentration is less than the first doping concentration. Thus, the second buried layer 128 can be referred to as a light buried layer.

An isolation trench 120 is provided that extends to a depth that exceeds the first depth of the first and second buried layers 118, 128. In some embodiments the isolation trench 120 may extend from the top surface 113 of the substrate to the base substate 112, or to the bottom surface of the substrate 111. The trench 120 comprises a polysilicon material. The isolation trench 120 enclosed or is perimetric to the second buried layer 128.

A first well region 116 is disposed between the top surface 113 and the buried layer 118. The first well region 116 has the second conductivity type, the same as the first and second buried layers. At least one electrical contact 124 is electrically connected to the first well region 116.

A second well region 126 is provided between the isolation trench 120 and the first well region 116. The second well region 126 is therefore perimetric to the first well region, as it surrounds the perimeter of the first well region 116. The isolation trench 120 is perimetric to the second well region 126.

The second well region 126 has the second conductivity type and a doping concentration that is less than the doping concentration of the first well region 116. In some embodiments, the second well region 126 may have a doping concentration that is the same as, or of the same order as, the second buried layer 128.

In use (see Figure 4) an active component is disposed in the first well region 116. The combination of the first well region 116, first buried layer 118 and the active component can be referred to as a high voltage (HV) tub. The structure shown in Figure 3 is configured to electrically isolate the active component from neighbouring components on the substrate 110. Optionally, the substrate 110 may comprise a plurality of structures as shown in Figure 3 (i.e., a plurality of isolation trenches 120, first and second buried layers 118, 128 and first and second well regions 116, 126), wherein each first well region 116 is configured to contain a respective active component. For simplicity, only a single isolation structure has been shown in Figure 3.

The second buried layer 128 acts as a spacer between the first buried layer 118 and the isolation trench 120. In practice, this changes the location of the breakdown region, which is represented by stars in Figure 3. As shown, the provision of the second buried layer 128 having a doping concentration that is less than the doping concentration of the first buried layer 118 spaces or translates the breakdown region away from the isolation trench 120 by a distance equal to the width of the second buried layer 128. In some embodiments, the second buried layer 128 may have a width of at least 1 µm. The second buried layer 128 may have a width equal to between 1 and 5 µm.

By moving the breakdown region away from the isolation trench 120 this reduces, or eliminates, breakdown voltage shift over time, even if the semiconductor device is exposed to high voltage and/or high temperatures for a prolonged period of time. In one particular embodiment, the breakdown voltage of the semiconductor device was tested, and the semiconductor device was then constantly stressed at 80V and 150°C for around 1 week. The breakdown voltage was then retested and was found to be only 0.5 V different to the initial breakdown voltage. Thus, in the semiconductor device shown in Figure 3, the breakdown voltage remains more stable or constant over time compared to the prior art devices.

Figure 4 shows a top view of the semiconductor device in Figure 3 according to an embodiment of the present disclosure.

As shown, an active component 130 is positioned within the first well region 116. Although the active component 130 is shown as positioned centrally within the first well region 116 in Figure 4, it will be appreciated that this is not limiting. The active component 130 may, for example, be a transistor or a diode, although any type of active component may be provided.

A plurality of electrical contacts 124 are provided on the top surface of the substrate in electrical contact with the first well region 116. The electrical contacts 124 control the potential of the first buried layer 118.

The second well region 126 surrounds (or is perimetric to) the first well region 116. The isolation trench 120 surrounds (or is perimetric to) the second well region 126. The at least one epitaxial layer 114 surrounds the isolation trench 120. In some embodiments, the at least one epitaxial layer 114 may be replaced by a single substrate 110. In Figure 4, the first buried layer 118 is not visible as this is provided underneath the first well region. Similarly, the second buried layer 128 is not visible as this is provided underneath the second well region 126.

It will be appreciated that Figure 4 is a schematic representation of a plan view of the semiconductor device, and the respective layers may have different shapes and relative sizes to those shown.

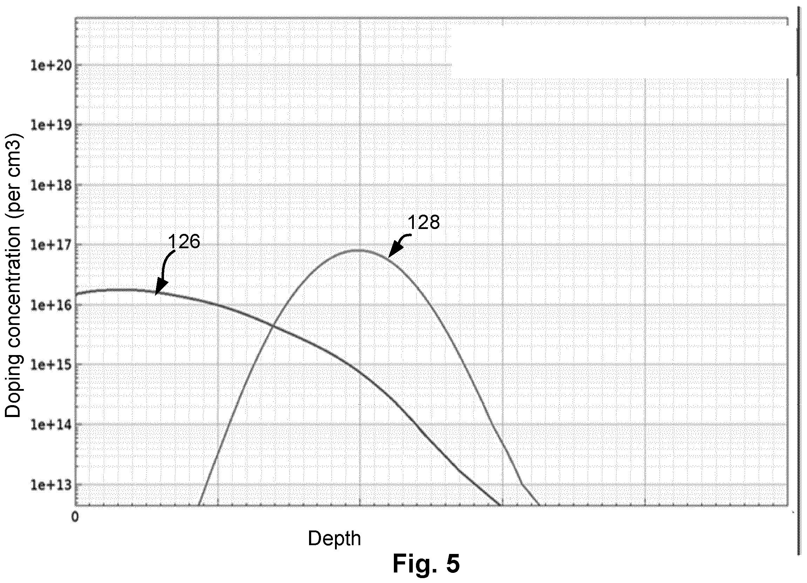

Figure 5 is a graph showing how doping concentration may vary with depth in the semiconductor along line A in Figure 3. Accordingly, the y axis is doping concentration per cm³, and the x axis is depth from the top surface of the substrate.

Line 126 in Figure 5 represents the second well region 126, which in this embodiment comprises a single doping species. In this embodiment the doping species is phosphorous, although other elements may be used. As the second well region 126 is the closest to the top surface of the substrate, this layer has the highest doping concentration towards x=0 along the cross-sectional line A (see Figure 3). In this embodiment the peak doping concentration for the second well region is off the order of 1 x10¹⁶ /cm³.

Line 128 in Figure 5 represents the second buried layer 128. As is shown in Figure 3, along cross-sectional line A the second buried layer 128 is positioned below (at a lower depth to) the second well region 116. In this embodiment, the second buried layer 128 comprises phosphorous, although other doping elements may be used. The peak doping concentration for the second buried layer 128 is between 1 x10¹⁶ /cm³ and 1 x10¹⁷ /cm³. As shown in Figure 5, the peak doping concentration for the second buried layer 128 in this embodiment is close to 1 x10¹⁷ /cm³.

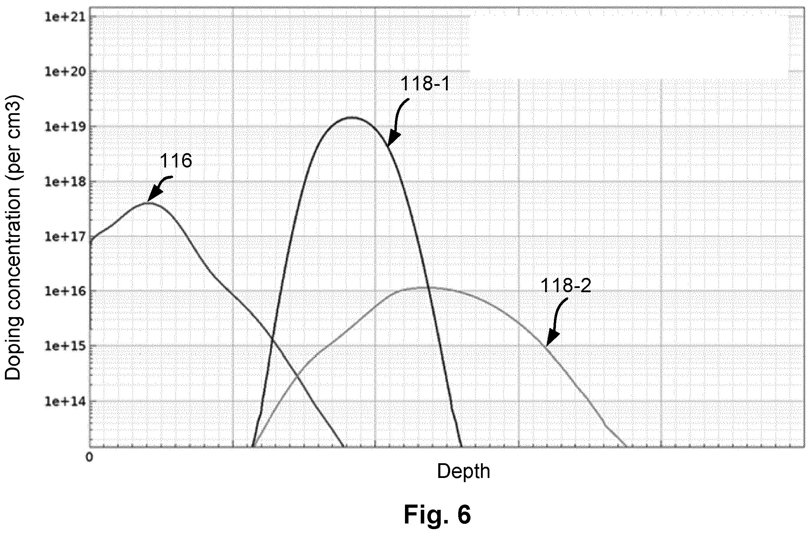

Figure 6 shows how doping concentration may vary with depth in the semiconductor along line B in Figure 3. Accordingly, the y axis is doping concentration per cm³, and the x axis is depth from the top surface of the substrate. Optionally, the x axis may be from 0 µm to 10 µm in both Figure 5 and 6, but it will be appreciated that this scale is not limiting and may vary depending on the particular application.

Line 116 in Figure 6 represents the first well region 116, which in this embodiment comprises a single doping species, wherein the single doping species is phosphorous, although other elements may be used. As the first well region 116 is the closest to the top surface of the substrate, this layer has the highest doping concentration towards x=0 along the cross-sectional line B (see Figure 3). In this embodiment the peak doping concentration for the first well region is between 1 x10¹⁷ /cm³ and 1 x10¹⁸ /cm³ (for example, around 5 x10¹⁷ /cm³). Accordingly, a comparison of Figures 5 and 6 shows that the first well region 116 has a higher peak doping concentration than the second well region 126.

In this embodiment, the first buried layer 118 is comprises two doping species, which are represented by lines 118-1 and 118-2. In this embodiment, line 118-1 represents the buried layer doped with antimony, and line 118-2 represents the buried layer doped with phosphorous. In other embodiments, different doping elements may be used and optionally only a single doping species may be used.

The antimony doped buried layer 118-1 has a peak doping concentration of the order of 1 x10¹⁹ /cm³, as shown in Figure 6. The phosphorous doped buried layer 118-2 has a lower peak doping concentration of the order of 1 x10¹⁶ /cm³.

A comparison of Figures 5 and 6 shows that the peak doping concentration of the second buried layer 128 is configured to be at a slightly lower depth in the substrate than the peak doping concentration of the antimony doped buried layer 118-1. This is to mitigate the lateral electric field strength at the edge of first buried layer, which has been found to improve the stability of the breakdown voltage.

It will be appreciated that the various semiconductor layers are not limited to the doping elements or concentrations described above or shown in Figure 5 or 6.

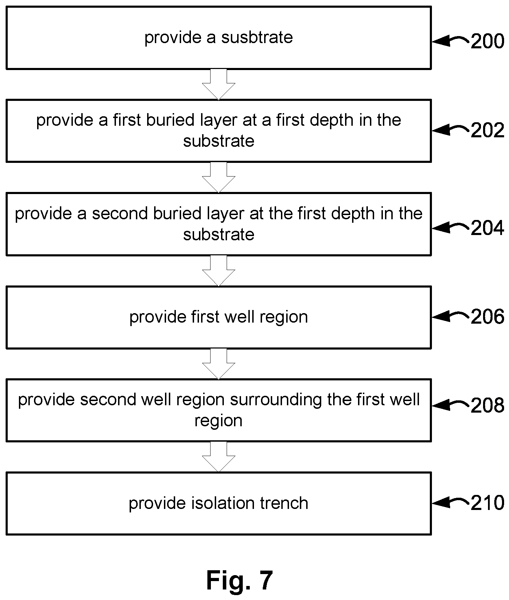

Figure 7 is a flowchart illustrating a method of manufacturing a semiconductor device according to an embodiment of the present disclosure.

In step 200 the method comprises providing a substrate 110. The substrate 110 may have a single layer, or multiple layers. The substrate 110 may have a first conductivity type, such as but not limited to p-type or positive type conductivity.

In step 202 the method comprises providing a first buried layer 118 at a first depth within the substrate 110. The first buried layer 118 may have a second conductivity type, such as but not limited to n-type or negative type conductivity. The first buried layer 118 has a first doping concentration.

In step 204 the method comprises providing a second buried layer 128 at the first depth within the substrate 110. The second buried layer 128 may have the second conductivity type, same as the first buried layer 118. The second buried layer 128 has a second doping concentration which is less than the first doping concentration of the first buried layer 118. In some embodiments, the first doping concentration may be of the order of 1000 times higher than the second doping concentration.

It will be appreciated that steps 202 and 204 may be combined in a single step.

Optionally, the substrate 110 may be provided as a base substrate with an epitaxial layer on top. The first and second buried layers 118, 128 may be implanted in the epitaxial layer. Between steps 204 and 206 there may be an intermediate step (not shown) of growing a second epitaxial layer on top of the first epitaxial layer and the first and second buried layers 118, 128.

In step 206 the method comprises providing a first well region 116 between the first buried layer 118 and a top surface of the substrate 110 (e.g., the top surface of the second epitaxial layer). Thus, the first well region 116 is stacked on top of the first buried layer 118 when viewed from above the substrate.

In step 208 a second well region 126 is provided perimetric to (or surrounding) the first well region. The second well region 126 may be stacked on top of the second buried layer, such that it is positioned between the second buried layer 128 and the top surface of the substrate.

The first and second well regions may have the second conductivity type, the same as the first and second buried layers. The doping concentration of both the first and second well regions may be less than the first doping concentration of the first buried layer.

It will be appreciated that steps 206 and 208 may be combined in a single step.

At step 210 an isolation trench 120 is inserted into the substrate. The isolation trench 120 surrounds, or is perimetric to, the second well region 126 and the second buried layer 128. The isolation trench 120 extends to a depth within the substate that exceeds the depth of the first and second buried layers 118, 128. The trench 120 may be filled, or partially filled, with a polysilicon material.

It will be appreciated that steps 200 to 210 could be carried out in a different order to the order shown in Figure 7.

Accordingly, there has been described a semiconductor device comprising a substrate having a first conductivity type, the substrate having a top surface and a bottom surface, a first buried layer disposed in the substrate at a first depth from the top surface, wherein the first buried layer has a second conductivity type and a first doping concentration, a second buried layer adjacent and surrounding the first buried layer at the first depth, wherein the second buried layer has the second conductivity type and a second doping concentration, wherein the second doping concentration is less than the first doping concentration, and an isolation trench disposed in the substrate and surrounding the second buried layer, wherein the isolation trench extends from the top surface of the substrate to a second depth, the second depth exceeding the first depth. A method of manufacture is also provided, as described above.

Although particular embodiments of this disclosure have been described, it will be appreciated that many modifications/additions and/or substitutions may be made within the scope of the claims.

## Claims

1. A semiconductor device comprising:
a substrate (110) having a first conductivity type, the substrate having a top surface (113) and a bottom surface (111);
a first buried layer (118) disposed in the substrate at a first depth from the top surface, wherein the first buried layer has a second conductivity type and a first doping concentration;
a second buried layer (128) adjacent and surrounding the first buried layer at the first depth, wherein the second buried layer has the second conductivity type and a second doping concentration, wherein the second doping concentration is less than the first doping concentration; and
an isolation trench (120) disposed in the substrate and surrounding the second buried layer wherein the isolation trench extends from the top surface of the substrate to a second depth, the second depth exceeding the first depth.

2. The semiconductor device of claim 1, wherein the first doping concentration is between 5x10¹⁸/cm³ and 5x10¹⁹/cm³.

3. The semiconductor device of claim 1 or claim 2, wherein the second doping concentration is between 5x10¹⁶/cm³ and 5x10¹⁷/cm³.

4. The semiconductor device of any preceding claim, wherein the substrate comprises a base substrate (112) and at least one epitaxial layer (114) disposed over the base substrate, wherein the isolation trench and the first and second buried layers are disposed in the at least one epitaxial layer.

5. The semiconductor device of any preceding claim, further comprising a first well region (116) disposed between the top surface of the substrate and the first buried layer, wherein the first well region has the second conductivity type.

6. The semiconductor device of claim 5, further comprising an active component (130) provided in the first well region.

7. The semiconductor device of claim 5 or claim 6, further comprising a second well region (126) disposed between the first well region (116) and the isolation trench (120), wherein the second well region has the second conductivity type and surrounds the first well region.

8. The semiconductor device of claim 7, wherein the second well region has a doping concentration that is of the same order as the second doping concentration.

9. The semiconductor device of any preceding claim, wherein a width of the second buried layer between the isolation trench and the first buried layer is less than a width of the first buried layer.

10. The semiconductor device of any preceding claim, wherein a width of the second buried layer between the isolation trench and the first buried layer is between 1 and 5 µm.

11. The semiconductor device of any preceding claim, wherein the isolation trench contains a polysilicon material.

12. The semiconductor device of any preceding claim, wherein the first and second buried layers have the same height.

13. The semiconductor device of any preceding claim, wherein the second buried layer is configured such that a breakdown region is spaced from the isolation trench.

14. The semiconductor device of claim 13, wherein:
the second buried layer is configured such that the breakdown region is located proximate a junction between the first buried layer and the second buried layer; or
the breakdown region is spaced from the isolation trench by a distance equal to the width of the second buried layer.

15. A method of manufacturing a semiconductor device, comprising:
providing a substrate (110) having a first conductivity type, the substrate having a top surface (113) and a bottom surface (111);
providing a first buried layer (118) in the substrate at a first depth from the top surface, wherein the first buried layer has a second conductivity type and a first doping concentration;
providing a second buried layer (128) adjacent and surrounding the first buried layer at the first depth, wherein the second buried layer has the second conductivity type and a second doping concentration, wherein the second doping concentration is less than the first doping concentration; and
providing an isolation trench (120) in the substrate surrounding the second buried layer,
wherein the isolation trench extends from the top surface of the substrate to a second depth, the second depth exceeding the first depth.

## Patentansprüche

1. Halbleiterbauelement, umfassend:
ein Substrat (110) mit einem ersten Leitfähigkeitstyp, das eine Oberseite (113) und eine Unterseite (111) aufweist;
eine erste vergrabene Schicht (118), die in einer ersten Tiefe von der Oberseite im Substrat angeordnet ist, wobei die erste vergrabene Schicht einen zweiten Leitfähigkeitstyp und eine erste Dotierungskonzentration aufweist;
eine zweite vergrabene Schicht (128), die an die erste vergrabene Schicht angrenzt und diese in der ersten Tiefe umgibt, wobei die zweite vergrabene Schicht den zweiten Leitfähigkeitstyp und eine zweite Dotierungskonzentration aufweist, wobei die zweite Dotierungskonzentration kleiner als die erste Dotierungskonzentration ist; und
einen Isolationsgraben (120), der im Substrat angeordnet ist und die zweite vergrabene Schicht umgibt, wobei sich der Isolationsgraben von der Oberseite des Substrats bis zu einer zweiten Tiefe erstreckt, die größer als die erste Tiefe ist.

2. Halbleiterbauelement nach Anspruch 1, wobei die erste Dotierungskonzentration zwischen 5x10¹⁸/cm³ und 5x10¹⁹/cm³ liegt.

3. Halbleiterbauelement nach Anspruch 1 oder Anspruch 2, wobei die erste Dotierungskonzentration zwischen 5x10¹⁶/cm³ und 5x10¹⁷/cm³ liegt.

4. Halbleiterbauelement nach einem der vorhergehenden Ansprüche, wobei das Substrat ein Basissubstrat (112) und mindestens eine über dem Basissubstrat angeordnete Epitaxialschicht (114) umfasst, wobei der Isolationsgraben und die erste und zweite vergrabene Schicht in der mindestens einen Epitaxialschicht angeordnet sind.

5. Halbleiterbauelement nach einem der vorhergehenden Ansprüche, ferner umfassend einen ersten Wannenbereich (116), der zwischen der Oberseite des Substrats und der ersten vergrabenen Schicht angeordnet ist, wobei der erste Wannenbereich den zweiten Leitfähigkeitstyp aufweist.

6. Halbleiterbauelement nach Anspruch 5, ferner umfassend eine im ersten Wannenbereich vorgesehene aktive Komponente (130).

7. Halbleiterbauelement nach Anspruch 5 oder Anspruch 6, ferner umfassend einen zweiten Wannenbereich (126), der zwischen dem ersten Wannenbereich (116) und dem Isolationsgraben (120) angeordnet ist, wobei der zweite Wannenbereich den zweiten Leitfähigkeitstyp aufweist und den ersten Wannenbereich umgibt.

8. Halbleiterbauelement nach Anspruch 7, wobei der zweite Wannenbereich eine Dotierungskonzentration aufweist, die in der gleichen Größenordnung liegt wie die zweite Dotierungskonzentration.

9. Halbleiterbauelement nach einem der vorhergehenden Ansprüche, wobei eine Breite der zweiten vergrabenen Schicht zwischen dem Isolationsgraben und der ersten vergrabenen Schicht kleiner als eine Breite der ersten vergrabenen Schicht ist.

10. Halbleiterbauelement nach einem der vorhergehenden Ansprüche, wobei eine Breite der zweiten vergrabenen Schicht zwischen dem Isolationsgraben und der ersten vergrabenen Schicht zwischen 1 und 5 µm liegt.

11. Halbleitervorrichtung nach einem der vorhergehenden Ansprüche, wobei der Isolationsgraben ein Polysiliziummaterial enthält.

12. Halbleitervorrichtung nach einem der vorhergehenden Ansprüche, wobei die erste und die zweite vergrabene Schicht die gleiche Höhe aufweisen.

13. Halbleitervorrichtung nach einem der vorhergehenden Ansprüche, wobei die zweite vergrabene Schicht so konfiguriert ist, dass ein Durchbruchbereich vom Isolationsgraben beabstandet ist.

14. Halbleitervorrichtung nach Anspruch 13, wobei:
die zweite vergrabene Schicht so konfiguriert ist, dass sich der Durchbruchbereich nahe eines Übergangs zwischen der ersten und der zweiten vergrabenen Schicht befindet; oder
der Durchbruchbereich vom Isolationsgraben um einen Abstand beabstandet ist, der der Breite der zweiten vergrabenen Schicht entspricht.

15. Verfahren zur Herstellung eines Halbleiterbauelements, umfassend:
Bereitstellen eines Substrats (110) mit einem ersten Leitfähigkeitstyp, das eine Oberseite (113) und eine Unterseite (111) aufweist;
Bereitstellen einer ersten vergrabenen Schicht (118) in einer ersten Tiefe von der Oberseite im Substrat, wobei die erste vergrabene Schicht einen zweiten Leitfähigkeitstyp und eine erste Dotierungskonzentration aufweist;
Bereitstellen einer zweiten vergrabenen Schicht (128), die an die erste vergrabene Schicht angrenzt und diese in der ersten Tiefe umgibt, wobei die zweite vergrabene Schicht den zweiten Leitfähigkeitstyp und eine zweite Dotierungskonzentration aufweist, wobei die zweite Dotierungskonzentration kleiner als die erste Dotierungskonzentration ist; und
Bereitstellen eines Isolationsgrabens (120), der im Substrat angeordnet ist und die zweite vergrabene Schicht umgibt, wobei sich der Isolationsgraben von der Oberseite des Substrats bis zu einer zweiten Tiefe erstreckt, die größer als die erste Tiefe ist.

## Revendications

1. Dispositif à semi-conducteur comportant :
un substrat (110) présentant un premier type de conductivité, le substrat présentant une surface supérieure (113) et une surface inférieure (111) ;
une première couche enterrée (118) disposée dans le substrat à une première profondeur par rapport à la surface supérieure, la première couche enterrée présentant un second type de conductivité et une première concentration de dopage ;
une seconde couche enterrée (128) adjacente à et entourant la première couche enterrée à la première profondeur, la seconde couche enterrée présentant le second type de conductivité et une seconde concentration de dopage, la seconde concentration de dopage étant inférieure à la première concentration de dopage ; et
une tranchée (120) d'isolation disposée dans le substrat et entourant la seconde couche enterrée, la tranchée d'isolation s'étendant à partir de la surface supérieure du substrat jusqu'à une seconde profondeur, la seconde profondeur dépassant la première profondeur.

2. Dispositif à semi-conducteur selon la revendication 1, la première concentration de dopage étant comprise entre 5x10¹⁸/cm³ et 5x10¹⁹/cm³.

3. Dispositif à semi-conducteur selon la revendication 1 ou la revendication 2, la seconde concentration de dopage étant comprise entre 5x10¹⁶/cm³ et 5x10¹⁷/cm³.

4. Dispositif à semi-conducteur selon l'une quelconque des revendications précédentes, le substrat comportant un substrat (112) de base et au moins une couche épitaxiale (114) disposée par-dessus le substrat de base, la tranchée d'isolation et les première et seconde couches enterrées étant disposées dans la ou les couches épitaxiales.

5. Dispositif à semi-conducteur selon l'une quelconque des revendications précédentes, comportant en outre une première région (116) de puits disposée entre la surface supérieure du substrat et la première couche enterrée, la première région de puits présentant le second type de conductivité.

6. Dispositif à semi-conducteur selon la revendication 5, comportant en outre un composant actif (130) placé dans la première région de puits.

7. Dispositif à semi-conducteur selon la revendication 5 ou la revendication 6, comportant en outre une seconde région (126) de puits disposée entre la première région (116) de puits et la tranchée (120) d'isolation, la seconde région de puits présentant le second type de conductivité et entourant la première région de puits.

8. Dispositif à semi-conducteur selon la revendication 7, la seconde région de puits présentant une concentration de dopage qui est du même ordre que la seconde concentration de dopage.

9. Dispositif à semi-conducteur selon l'une quelconque des revendications précédentes, une largeur de la seconde couche enterrée entre la tranchée d'isolation et la première couche enterrée étant inférieure à une largeur de la première couche enterrée.

10. Dispositif à semi-conducteur selon l'une quelconque des revendications précédentes, une largeur de la seconde couche enterrée entre la tranchée d'isolation et la première couche enterrée étant comprise entre 1 et 5 µm.

11. Dispositif à semi-conducteur selon l'une quelconque des revendications précédentes, la tranchée d'isolation contenant un matériau de polysilicium.

12. Dispositif à semi-conducteur selon l'une quelconque des revendications précédentes, les première et seconde couches enterrées présentant la même hauteur.

13. Dispositif à semi-conducteur selon l'une quelconque des revendications précédentes, la seconde couche enterrée étant configurée de telle façon qu'une région de rupture soit espacée par rapport à la tranchée d'isolation.

14. Dispositif à semi-conducteur selon la revendication 13 :
la seconde couche enterrée étant configurée de telle façon que la région de rupture soit située à proximité d'une jonction entre la première couche enterrée et la seconde couche enterrée ; ou
la région de rupture étant espacée par rapport à la tranchée d'isolation d'une distance égale à la largeur de la seconde couche enterrée.

15. Procédé de fabrication d'un dispositif à semi-conducteur, comportant les étapes consistant à :
mettre en place un substrat (110) présentant un premier type de conductivité, le substrat présentant une surface supérieure (113) et une surface inférieure (111) ;
mettre en place une première couche enterrée (118) dans le substrat à une première profondeur par rapport à la surface supérieure, la première couche enterrée présentant un second type de conductivité et une première concentration de dopage ;
mettre en place une seconde couche enterrée (128) adjacente à et entourant la première couche enterrée à la première profondeur, la seconde couche enterrée présentant le second type de conductivité et une seconde concentration de dopage, la seconde concentration de dopage étant inférieure à la première concentration de dopage ; et
mettre en place une tranchée (120) d'isolation dans le substrat entourant la seconde couche enterrée, la tranchée d'isolation s'étendant à partir de la surface supérieure du substrat jusqu'à une seconde profondeur, la seconde profondeur dépassant la première profondeur.
